(19) Europäisches Patentamt / European Patent Office / Office européen des brevets

(11) **EP 2 806 995 B1**

(12) **EUROPÄISCHE PATENTSCHRIFT**

(45) Veröffentlichungstag und Bekanntmachung des Hinweises auf die Patenterteilung:
**04.05.2016   Patentblatt 2016/18**

(21) Anmeldenummer: **12803512.8**

(22) Anmeldetag: **04.12.2012**

(51) Int Cl.:
*B23K 26/00* *(2014.01)*   *B23K 26/36* *(2014.01)*
*B23K 26/40* *(2014.01)*   *H01L 27/142* *(2006.01)*
*G03F 7/20* *(2006.01)*   *H01L 21/027* *(2006.01)*
*H01L 31/18* *(2006.01)*

(86) Internationale Anmeldenummer:
**PCT/EP2012/074337**

(87) Internationale Veröffentlichungsnummer:
**WO 2013/110384 (01.08.2013 Gazette 2013/31)**

(54) **VERFAHREN ZUR HERSTELLUNG EINES STRUKTURIERTEN MEHRSCHICHTSYSTEMS UNTER VERWENDUNG VON EIGENINTERFERENZFÄHIGER BEARBEITUNGSSTRAHLUNG**

METHOD OF PRODUCING A STRUCTURED MULTI-LAYER SYSTEM USING A PROCESSING BEAM WITH EIGEN INTERFERENCES

PROCÉDÉ DE FABRICATION D'UN SYSTÈME MULTICOUCHE STRUCTURÉ UTILISANT UN FAISCEAU DE TRAVAIL AVEC DES INTERFERENCES PROPRES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.01.2012   DE 102012200915**

(43) Veröffentlichungstag der Anmeldung:
**03.12.2014   Patentblatt 2014/49**

(73) Patentinhaber: **Robert Bosch GmbH**
**70442 Stuttgart (DE)**

(72) Erfinder:
• **DIEZ, Michael**
**71672 Marbach (DE)**
• **GAUCH, Roland**
**71701 Schwieberdingen (DE)**
• **LETSCH, Andreas**
**70565 Stuttgart (DE)**

(56) Entgegenhaltungen:
**US-A1- 2005 084 768     US-A1- 2008 173 473**
**US-A1- 2009 170 239**

**Beschreibung**

Die Erfindung betrifft ein Verfahren zur Herstellung eines strukturierten Mehrschichtsystems unter Einsatz von eigeninterferenzfähiger Bearbeitungsstrahlung einer Wellenlänge, für die mindestens eine Schicht des Mehrschichtsystems partiell durchlässig ist gemäß dem Oberbegriff der Ansprüche 1 und 2 (siehe, z.B., US 2008/0173473).

Stand der Technik

Die Mikrobearbeitung mit Lasern hat sich insbesondere bei Applikationen durchsetzen können, bei denen die hohe Präzision des Abtrags ein notwendiges Kriterium darstellt.

Mit der Verwendung immer kürzerer Pulsdauern kann die Präzision des Abtrags deutlich verbessert und die Schädigung des umliegenden Materials weiter verringert werden. Dabei steigen die Kosten für ein Lasersystem mit der Verkürzung der Pulsdauer von Nano- über Pico- bis zu Femtosekunden massiv an. Aus diesem Grund ist die Anzahl industrieller Applikationen für Pikosekundenlaser noch überschaubar und für Femtosekundenläser minimal.

Ein weiterer Ansatz zur Verringerung der Schädigung umliegenden Materials wird über eine Anpassung der Wellenlänge des Lasers erreicht. Zum einen steigt mit einer Verkürzung der Wellenlänge bei vielen Materialien die Absorption an, wodurch gleichzeitig die optische Eindringtiefe reduziert wird. Das heißt, die Laserpulsenergie wird in einem kleineren Volumen oberflächennah deponiert, wodurch kleinere Abtragstiefen realisiert werden können.

Zum anderen kann bei Mehrschichtsystemen, wie z. B. bei Solarzellen, in der Mikroelektronik oder der Bildschirmtechnik oft eine Laserwellenlänge gewählt werden, die stärker in der gewünschten Schicht absorbiert wird und durch andere Schichten transmittiert.

Auch bei der Wellenlänge steigt für Mikrobearbeitungslaser mit guter Strahlqualität der Preis deutlich mit der Verringerung der Wellenlänge an. Da diese meist über Frequenzkonversion erzeugt wird, sind zusätzlich die verfügbaren mittleren Leistungen und Pulsenergien bei grünen oder UV-Lasern deutlich geringer als bei IR-Lasern.

Sehr sensible Prozesse wie z.B. der selektive Schichtabtrag bei organischen Solarzellen stellen selbst mit sehr teuren Ultrakurzpulslasern noch eine große Herausforderung dar.

Bereits in der Vergangenheit wurden für die Bearbeitung von Mehrschichtsystemen mit Laserstrahlung Betrachtungen hinsichtlich der Bedeutung von Interferenz der von verschiedenen Oberflächen des Mehrschichtsystems reflektierten Strahlung angestellt. Derartige Betrachtungen finden sich etwa in der US 2002/0094008, der US 2002/0162973, der US 2005/0212906 oder der US 2008/0173473.

Offenbarung der Erfindung

Gemäß einem ersten Aspekt der Erfindung wird ein Verfahren mit den Merkmalen des Anspruchs 1 vorgeschlagen, und gemäß einem relativ unabhängigen zweiten Aspekt der Erfindung wird ein Verfahren mit den Merkmalen des Anspruchs 2 vorgeschlagen.

Zweckmäßige Fortbildungen des Erfindungsgedankens gemäß dem ersten und/oder zweiten Aspekt sind Gegenstand der abhängigen Ansprüche.

Die Erfindung geht von der Überlegung aus, dass neben den weiter oben erwähnten Prozessvariablen bei der Bearbeitung von Mehrschichtsystemen mittels energiereicher Strahlung die Verfügbarkeit einer zusätzlichen Prozessvariablen wünschenswert ist. Mit der Erfindung wird eine Möglichkeit eröffnet, neben der gezielten Vorgabe der mittleren Leistung (bzw., bei gepulster Laserstrahlung, der Impulsdauer oder dem Aspektverhältnis) und der Wellenlänge bzw. dem Wellenlängenspektrum der Bearbeitungsstrahlung und gegebenenfalls deren Einschalt- bzw. Einstrahlwinkel die Strahlungsenergie gezielter und selektiver in ausgewählten Schichten des Systems zu deponieren.

Betrachtet man allgemein ein Schichtsystem, in dem die abzutragende Schicht eine Dicke in der Größenordnung der Laserwellenlänge aufweist, so kann die Interferenzbedingung wie folgt formuliert werden:

$$2 \cdot n \cdot d = \frac{\lambda}{2}$$

wobei n der Brechungsindex der Schicht, d die Schichtdicke und λ die Laserwellenlänge darstellt. Diese Gleichung beschreibt die destruktive Interferenz der direkt reflektierten Strahlung mit der Strahlung, die einmal durch die Schicht transmittiert ist und an der nächsten Grenzschicht wieder zurückreflektiert wird.

Die Einhaltung der Interferenzbedingung sorgt dafür, dass die reflektierten Strahlen destruktiv interferieren. Dadurch verbleibt diese Energie in der Schicht. Damit steht ein größerer Anteil der Pulsenergie zur Modifikation dieser Schicht zur Verfügung. Ebenso ist es bei einem Mehrschichtsystem möglich, durch positive Interferenz der reflektierten Strahlen in einer Schicht mehr Energie in die darüber liegende Schicht zurückzureflektieren.

Durch eine geschickte Kombination von positiver und negativer Interferenz an übereinander liegenden Schichten kann mithin die Energiedeposition in der gewünschten Schicht stark vergrößert werden, bei gleichzeitiger Minimierung der Energiedeposition in der anderen Schicht. Damit kann z. B. eine Schicht besser abgetragen werden, wobei gleichzeitig eine angrenzende Schicht weniger oder gar nicht geschädigt wird.

Bei einer ersten Ausführung liegt die erste Schicht, bezogen auf die Einstrahlrichtung der Bearbeitungsstrahlung, über der zweiten Schicht. Die Ausführung der Erfindung ist jedoch auch bei Mehrschichtsystemen möglich, die mit mehr als einer ersten Schicht, die zur Ausbildung destruktiver Interferenz bemessen ist, und/oder mehr als einer zweiten Schicht, die zur Ausbildung konstruktiver Interferenz bemessen ist, aufgebaut sind. Hierbei kann also auch eine Schicht vom ersten Typ (wiederum bezogen auf die Einstrahlrichtung) unter einer Schicht vom zweiten Typ liegen und das Verfahren gleichwohl erfindungsgemäß ausgeführt werden.

In einer weiteren Ausführung erfolgt die Verfahrensführung derart, dass dann bei vorgegebener Wellenlänge und Intensität (Fluenz und Pulsdauer) für die vorbestimmten Einfallswinkel der Bearbeitungsstrahlung die erste Schicht mit einer zur Ausbildung destruktiver Interferenz geeigneter Dicke und/oder die zweite Schicht mit einer zur Ausbildung konstruktiver Interferenz geeigneten Dicke erzeugt wird. Mit anderen Worten wird also das Parameter-Ensemble der Bearbeitungsstrahlung als gegeben und für eine bestimmte Mehrschichtstruktur grundsätzlich geeignet angesehen, und wird die Schichtdicke bestimmter Schichten bei deren Erzeugung gezielt eingestellt.

Speziell wird auch, in weiteren Ausführungen, eine im Wesentlichen senkrechte Einstrahlung des Bearbeitungsstrahls auf die Oberfläche des Schichtsystems als zweckmäßig vorgewählt. Unter "im Wesentlichen senkrecht" werden hierbei Einstrahlungen verstanden, bei denen die erfindungsgemäß ausgenutzten Effekte der destruktiven und/oder konstruktiven Interferenz hinreichend wirksam auftreten. In Abhängigkeit von den konkreten Bestrahlungsparametern kommen gegebenenfalls auch deutlich unter 90° liegende Einstrahlwinkel in Betracht.

In einer aus derzeitiger Sicht wichtigen Applikation des Verfahrens handelt es sich bei der Mehrschichtstruktur um diejenige einer Solarzelle, insbesondere einer Dünnschicht-Solarzelle, z. B. organischen Solarzelle o.ä. Hierbei kann speziell vorgesehen sein, dass als eine "erste Schicht" (im Sinne der obigen Bezeichnungen) eine Absorberschicht oder eine leitende Oxidschicht und als eine zweite Schicht eine Kunststoff-Folie oder Pufferschicht vorliegen.

Zu dieser wichtigen Applikation ist erläuternd Folgendes anzumerken:

Speziell kann die Absorberschicht bei organischen Solarzellen dergestalt optimiert werden, dass sie der destruktiven Interferenzbedingung der Laserwellenlänge gehorcht.

Eine Herausforderung bei der P1-Laserablation bei der organischen Photovoltaik rührt z. B. daher, dass die Abtragsschwelle der transparenten leitenden Oxidschicht höher ist als die der darunter liegenden Kunststoff-Folie.

Liegt unter der transparenten leitenden Oxidschicht noch eine Pufferschicht, so kann die Schichtdicke dahingehend optimiert werden, da sie zur konstruktiven Interferenz führt. Damit kann die Materialmodifikationsschwelle erhöht werden, und ein ungewolltes Modifizieren der Pufferschicht wird erschwert. Des Weiteren wird die rückreflektierte Leistung wieder in der darüber liegenden Schicht absorbiert und verringert damit die Ablationsschwelle dieser Schicht. Gleichzeitig transmittiert weniger Leistung in die darunter liegende Schicht, und damit wird diese geschont.

Andere wichtige Anwendungsgebiete sind die allgemeine Halbleitertechnologie, speziell Schaltkreiskonfigurationen mit strukturierten Mehrschichtsystemen, die besonders dünne bzw. besonders empfindliche Schichten umfassen, sowie organische halbleitende Strukturen, wie sie etwa bei modernen Displays zu finden sind (OLED etc.) eingesetzt werden. Die konkrete Verfahrensführung erfordert neben den oben erwähnten Variablen jeweils auch die Berücksichtigung des Transmissions- bzw. Absorptionskoeffizienten der einzelnen Schichten des Mehrschichtsystems, bei der spezifischen Bearbeitungsstrahlung sowie der Wärmeleitfähigkeiten, und gegebenenfalls sind bei der Bearbeitung Kühlmittel einzusetzen und deren Einfluss auf den Prozess zu berücksichtigen. Entsprechende Abschätzungen liegen aber im Rahmen des Könnens des Fachmanns.

Zeichnungen

Weitere Vorteile und vorteilhafte Ausgestaltungen der erfindungsgemäßen Gegenstände werden durch die Zeichnungen veranschaulicht und in der nachfolgenden Beschreibung erläutert. Dabei ist zu beachten, dass die Zeichnungen nur beschreibenden Charakter haben und nicht dazu gedacht sind, die Erfindung in irgendeiner Form einzuschränken. Es zeigen:

Fig. 1    eine schematische Querschnittsdarstellung der Anwendung des vorgeschlagenen Verfahrens bei einem Mehrschichtsystem,

Fig. 2    eine schematische Querschnittsdarstellung einer weiteren Anwendung des Verfahrens bei einem weiteren Mehrschichtsystem und

Fig. 3    eine perspektivische Schnittansicht des Schichtsystems einer Dünnschicht-Solarzelle als Beispiel für ein erfindungsgemäß herzustellendes strukturiertes Mehrschichtsystem.

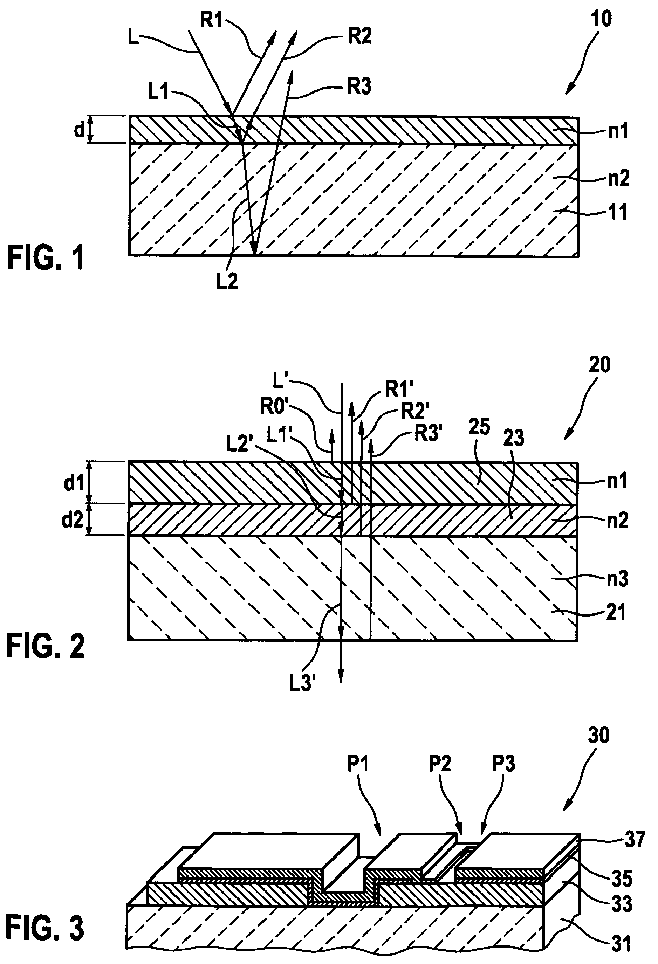

Fig. 1 zeigt ein Mehrschichtsystem 10 mit einer auf einem Si-Substrat 11 mit einem Brechungsindex n1 erzeugten SiN-Schicht 13, die eine Dicke d und einen Brechungsindex n2 hat. Ein Bearbeitungs-Laserstrahl L wird auf das Schichtsystem eingestrahlt und unterliegt an der Oberfläche der Schicht einer ersten Reflexion R1, wobei ein geschwächter Laserstrahl L1 in die Schicht 13 eindringt, und an der Grenzfläche der Schichten 13 und 11 einer zweiten Reflexion R2. Nach dieser verbleibt ein in das Si-Substrat 11 transmittierter Strahlungsanteil L2 und an der Rückseite des Si-Substrats 11 folgt eine weitere Reflexion R3. Bei jedem Schichtdurchgang tritt natürlich auch eine Absorption auf.

Die die Schicht 13 durchsetzenden Strahlungsanteile (speziell R2 und R3) sind interferenzfähig, und durch geeignete Einstellung der Schichtdicke d und der Strahlungsparameter kann unter Nutzung des Effekts der destruktiven Interferenz erreicht werden, dass die in der Schicht 13 in Wärme umgesetzten Strahlungsanteile oberhalb einer schichtspezifischen Modifikationsschwellenenergie liegen, also beispielsweise einen Abtrag oder ein Aufschmelzen von Schichtteilen im Wirkbereich der Laserstrahlung L bewirken. Andererseits ermöglicht es die Nutzung des Effekts der destruktiven Interferenz, d.h. einer auf die Schicht 13 beschränkten Strahlungsverstärkung, die primär eingestrahlte mittlere Laserstrahlenergie so gering zu halten, dass der in die Si-Schicht 11 transmittierte Anteil L2 dort mit Sicherheit keine Schädigungen hervorruft.

Fig. 2 zeigt als weiteres Beispiel der Ausführung der Erfindung ein Dreischichtsystem 20 mit einer Substratschicht 21 mit einem Brechungsindex n3, einer Zwischenschicht 23 mit einer Dicke d2 und einem Brechungsindex n2 und einer Deckschicht 25 mit einer Dicke d1 und einem Brechungsindex n1. In analoger Weise wie bei Fig. 1 sind die eingestrahlte Strahlung und die transmittierten Strahlungsanteile mit L', L1', L2' und L3' und die an der Oberfläche des Schichtsystems bzw. den weiteren reflektierenden Flächen reflektierten Strahlungsanteilen R0', R1', R2' und R3' bezeichnet.

Bei diesem Schichtsystem treten Interferenzeffekte sowohl der Zwischenschicht 23 als auch in der Deckschicht 25 auf und können durch Erzeugung ihrer Schichten mit geeigneter Dicke in gewünschter Weise gesteuert werden. Speziell kann, wenn die Zwischenschicht 23 aus einem empfindlichen Material besteht und nicht beschädigt werden soll, deren Dicke d2 zur Erzielung der weiter oben erwähnten konstruktiven Interferenz (und hierdurch schichtbezogenen Schwächung der Strahlung) gewählt werden, während zur erfolgreichen Strukturierung der Deckschicht 25 bzw. zur Ablation von Schichtanteilen deren Dicke d1 gezielt zur Hervorrufung destruktiver Interferenz bemessen wird.

Fig. 3 zeigt schematisch eine organische Photovoltaikzelle 30, die aus mehreren sehr dünnen Schichten (mit Dicken in der Größenordnung der Wellenlänge von kommerziell verfügbaren Bearbeitungs-Lasern) aufgebaut ist und daher in vorteilhafter Weise mit einer geeigneten Ausgestaltung des erfindungsgemäßen Verfahrens strukturiert werden kann, im bereits strukturierten Zustand. Die Zelle 30 umfasst ein PET-Substrat 31, eine Frontkontaktschicht (ITO) 33, eine organische Absorberschicht 35 und eine Rückkontaktschicht 37.

In an sich bekannter Weise sind zur Strukturierung in diesem Schichtsystem Abtragspuren erzeugt, die üblicherweise als P1, P2 und P3 bezeichnet werden. P1 stellt einen Graben in der Frontkontaktschicht 33 (mit in den Graben abgesenkter Absorber- und Rückkontaktschicht), P2 einen Graben in der Absorberschicht mit auf die Frontkontaktschicht abgesenkter Rückkontaktschicht und P3 einen offenen Graben in der Absorber- und Rückkontaktschicht dar, um Schädigungen des empfindlichen PET-Substrats bzw. von Schichten, die bei einer Strukturierung jeweils erhalten bleiben sollen, zu vermeiden, muss die Bearbeitungs-Laserstrahlung der Erzeugung der erwähnten Strukturen in ihren Parametern mit höchster Sorgfalt eingestellt werden. Der Technik sind hier enge Grenzen gesetzt, die sich durch geeignete Wahl der Schichtdicken, speziell der Frontkontaktschicht 33 und der Absorberschicht 35, zur Ausnutzung der Effekte der destruktiven Interferenz und/oder konstruktiven Interferenz erheblich weiter ziehen lassen. Dies ermöglicht bei der Herstellung von Solarzellen dieser oder ähnlicher Art größere Prozessfenster und führt zu höherer Prozesssicherheit.

**Patentansprüche**

1. Verfahren zur Herstellung eines strukturierten Mehrschichtsystems (20) unter Einsatz von eigeninterferenzfähiger Bearbeitungsstrahlung (L) einer Wellenlänge, für die mindestens eine Schicht des Mehrschichtsystems partiell durchlässig ist, **dadurch gekennzeichnet, daß** die Schichtdicke (d; d1) mindestens einer ersten partiell durchlässigen Schicht (13; 25), die Wellenlänge und Intensität der Bearbeitungsstrahlung und deren Einfallswinkel derart vorbestimmt werden, dass in der ersten Schicht im Einwirkungsbereich der Bearbeitungsstrahlung infolge destruktiver Interferenz ein erhöhter Energiebetrag absorbiert wird, der gleich einer Modifikations-Schwellenenergie der ersten Schicht ist oder geringfügig über dieser liegt.

2. Verfahren zur Herstellung eines strukturierten Mehrschichtsystems (20) unter Einsatz von eigeninterferenzfähiger Bearbeitungsstrahlung (L) einer Wellenlänge, für die mindestens eine Schicht des Mehrschichtsystems partiell durchlässig ist, **dadurch gekennzeichnet, daß** die Schichtdicke (d2) mindestens einer zweiten partiell durchlässigen Schicht (23), die Wellenlänge und Intensität der Bearbeitungsstrahlung und deren Einfallswinkel derart vorbestimmt werden, dass in der zweiten Schicht im Einwirkungsbereich der Bearbeitungsstrahlung infolge konstruktiver Interferenz ein verringerter Energiebetrag absorbiert wird, der unterhalb einer Modifikations-Schwellenenergie der zweiten Schicht liegt.

3. Verfahren nach Anspruch 1 und Anspruch 2, wobei die erste Schicht (25), bezogen auf die Einstrahlrichtung der Bearbeitungsstrahlung, über der zweiten Schicht (23) liegt.

4. Verfahren nach einem der vorangehenden Ansprüche,

wobei bei vorgegebener Wellenlänge und Intensität für die vorbestimmten Einfallswinkel der Bearbeitungsstrahlung (L) die erste Schicht (25) mit einer zur Ausbildung destruktiver Interferenz geeigneten Dicke (d1) und/oder die zweite Schicht (23) mit einer zur Ausbildung konstruktiver Interferenz geeigneten Dicke (d2) erzeugt wird.

**5.** Verfahren nach einem der vorangehenden Ansprüche,
wobei die Bearbeitungsstrahlung (L) im Wesentlichen senkrecht auf die Oberfläche des Mehrschichtsystems eingestrahlt wird.

**6.** Verfahren nach einem der vorangehenden Ansprüche,
wobei als Bearbeitungsstrahlung (L) ein gepulster Laserstrahl eingesetzt wird.

**7.** Verfahren nach einem der vorangehenden Ansprüche,
wobei das Mehrschichtsystem mit mehr als einer ersten Schicht, die zur Ausbildung destruktiver Interferenz bemessen ist, und/oder mehr als einer zweiten Schicht, die zur Ausbildung konstruktiver Interferenz bemessen ist, aufgebaut ist.

**8.** Verfahren nach einem der vorangehenden Ansprüche,
wobei das Mehrschichtsystem das einer Solarzelle (30), insbesondere einer Dünnschicht-Solarzelle, ist.

**9.** Verfahren nach Anspruch 8,
wobei als eine erste Schicht eine Absorberschicht (35) oder leitende Oxidschicht (33) und als eine zweite Schicht eine Kunststoff-Folie (31) oder Pufferschicht vorliegen.

**10.** Verfahren nach Anspruch 8,
wobei das Mehrschichtsystem das einer kristallinen Solarzelle ist.

**Claims**

**1.** Method for producing a structured multi-layer system (20) using processing radiation (L) capable of self interference, of a wavelength for which at least one layer of the multi-layer system is partially permeable, **characterized in that** the layer thickness (d; d1) of at least one first partially permeable layer (13; 25), the wavelength and intensity of the processing radiation and its angle of incidence are predetermined in such a way that an increased amount of energy, equal to a modification threshold energy of the first layer or slightly above that, is absorbed in the first layer in the area of exposure to the processing radiation as a result of destructive interference.

**2.** Method for producing a structured multi-layer system (20) using processing radiation (L) capable of self interference, of a wavelength for which at least one layer of the multi-layer system is partially permeable, **characterized in that** the layer thickness (d2) of at least one second partially permeable layer (23), the wavelength and intensity of the processing radiation and its angle of incidence are predetermined in such a way that a reduced amount of energy, below a modification threshold energy of the second layer, is absorbed in the second layer in the area of exposure to the processing radiation as a result of constructive interference.

**3.** Method according to Claim 1 and Claim 2,
wherein the first layer (25) lies over the second layer (23), with respect to the irradiating direction of the processing radiation.

**4.** Method according to one of the preceding claims,
wherein, with a given wavelength and intensity for the predetermined angle of incidence of the processing radiation (L), the first layer (25) is created with a thickness (d1) suitable for the formation of destructive interference and/or the second layer (23) is created with a thickness (d2) suitable for the formation of constructive interference.

**5.** Method according to one of the preceding claims,
wherein the processing radiation (L) is irradiated onto the surface of the multi-layer system substantially perpendicularly.

**6.** Method according to one of the preceding claims,
wherein a pulsed laser beam is used as the processing radiation (L).

**7.** Method according to one of the preceding claims,
wherein the multi-layer system is constructed with more than one first layer, dimensioned for the formation of destructive interference, and/or more than one second layer, dimensioned for the formation of constructive interference.

**8.** Method according to one of the preceding claims,
wherein the multi-layer system is that of a solar cell (30), in particular a thin-film solar cell.

**9.** Method according to Claim 8,
wherein an absorber layer (35) or conducting oxide film (33) is present as a first layer and a film of plastic (31) or buffer layer is present as a second layer.

**10.** Method according to Claim 8,
wherein the multi-layer system is that of a crystalline solar cell.

**Revendications**

1. Procédé de fabrication d'un système multicouche structuré (20) en recourant à un rayonnement de traitement (L) apte à former des auto-interférences et d'une longueur d'onde pour laquelle au moins une couche du système multicouche est partiellement transparente, **caractérisé en ce que** l'épaisseur (d ; d1) d'au moins une première couche (13 ; 25) partiellement transparente, la longueur d'onde et l'intensité du rayonnement de traitement ainsi que son angle d'incidence sont prédéterminés de telle sorte que dans la plage d'action du rayonnement de traitement, une quantité accrue d'énergie, égale à une énergie de seuil de modification de la première couche ou légèrement supérieure à cette dernière, soit absorbée dans la première couche suite à des interférences destructrices.

2. Procédé de fabrication d'un système multicouche structuré (20) en recourant à un rayonnement de traitement (L) apte à former des auto-interférences et d'une longueur d'onde pour laquelle au moins une couche du système multicouche est partiellement transparente, **caractérisé en ce que** l'épaisseur (d2) d'au moins une deuxième couche (23) partiellement transparente, la longueur d'onde et l'intensité du rayonnement de traitement et son angle d'incidence sont prédéterminés de telle sorte que dans la plage d'action du rayonnement de traitement, une quantité réduite d'énergie, qui est inférieure à une énergie de seuil de modification de la deuxième couche, soit absorbée dans la deuxième couche suite à des interférences constructrices.

3. Procédé selon la revendication 1 et la revendication 2, dans lequel la première couche (25) est située au-dessus de la deuxième couche (23) dans la direction d'émission du rayonnement de traitement.

4. Procédé selon l'une des revendications précédentes, dans lequel pour la longueur d'onde prédéterminée et l'intensité prédéterminée, ainsi que pour l'angle d'incidence prédéterminé du rayonnement de traitement (L), la première couche (25) est formée à une épaisseur (d1) qui convient pour obtenir une interférence destructrice et/ou la deuxième couche (23) est formée à une épaisseur (d2) qui convient pour obtenir une interférence constructrice.

5. Procédé selon l'une des revendications précédentes, dans lequel le rayonnement de traitement (L) est appliqué essentiellement perpendiculairement sur la surface du système multicouche.

6. Procédé selon l'une des revendications précédentes, dans lequel un rayonnement laser pulsé est utilisé comme rayonnement de traitement (L).

7. Procédé selon l'une des revendications précédentes, dans lequel le système multicouche présente plus qu'une première couche dimensionnée pour permettre une interférence destructrice et/ou plus d'une deuxième couche dimensionnée pour obtenir une interférence constructrice.

8. Procédé selon l'une des revendications précédentes, dans lequel le système multicouche est celui d'une cellule solaire (30) et en particulier d'une cellule solaire en couches minces.

9. Procédé selon la revendication 8, dans lequel la première couche est une couche d'absorption (35) ou une couche d'oxyde conducteur (33) et la deuxième couche est une feuille de matière synthétique (31) ou une couche tampon.

10. Procédé selon la revendication 8, dans lequel le système multicouche est celui d'une cellule solaire cristalline.

**FIG. 1**

**FIG. 2**

**FIG. 3**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20080173473 A
- US 20020094008 A
- US 20020162973 A
- US 20050212906 A